# EUROPÄISCHE PATENTSCHRIFT

(11) **EP 3 993 238 B1**
(45) Veröffentlichungstag und Bekanntmachung des Hinweises auf die Patenterteilung: **03.12.2025**
(21) Anmeldenummer: 20204647.0
(22) Anmeldetag: 29.10.2020
(51) Int. Cl.: H02K 11/026, H05K 1/02

(54) **FILTERSCHALTUNG AN EINEM ELEKTROMOTOR**
FILTER CIRCUIT ON AN ELECTRIC MOTOR
MONTAGE FILTRE SUR UN MOTEUR ÉLECTRIQUE

(43) Veröffentlichungstag der Anmeldung: 04.05.2022
(73) Patentinhaber: Andreas Stihl AG & Co. KG, 71336 Waiblingen (DE)
(72) Erfinder: Harjung, Philipp, 71409 Schwaikheim (DE); Fürst, Martin, 85053 Ingolstadt (DE); Rühle, Alexander, 73630 Remshalden (DE)
(74) Vertreter: Wasmuth, Rolf

(56) Entgegenhaltungen:
- DE-A1- 102004 056 041
- DE-A1- 102006 044 304
- KINNAIRD CLARK ET AL: "Addressing EMI challenges for high side switches and motor drivers in body electronics", 30 September 2020 (2020-09-30), XP055792041, Retrieved from the Internet <URL:https://www.ti.com/lit/ml/slyp697/slyp697.pdf?ts=1617182325579&ref_url=https%3A%2F%2Fwww.google.com%2F> [retrieved on 20210331]

## Beschreibung

Die Erfindung betrifft eine Filterschaltung an einem Elektromotor, der Anschlüsse zur elektrischen Verbindung mit einer Versorgungsspannung aufweist. Die elektrischen Anschlüsse des Elektromotors sind auf einer Anschlussseite des Elektromotors vorgesehen. Die Filterschaltung weist zumindest eine zwischen den elektrischen Anschlüssen des Elektromotors angeordnete Kondensatorbrücke auf, um eine elektrische Entstörung zu erzielen. Derartige Filterschaltungen sind aus der DE 10 2004 056 041 A1 oder der DE 10 2006 044 304 A1 bekannt.

In der Praxis zeigt sich immer wieder, dass insbesondere in bestimmten Lastzuständen des Elektromotors die auftretende elektromagnetische Störabstrahlung zu einer erheblichen elektromagnetischen Beeinträchtigung des Umfeldes führt. Akkubetriebene Werkzeuge sind mobil an vielen Orten einsetzbar, wodurch die Störquellen mobil auftreten und daher schwer zu lokalisieren sind.

Der Erfindung liegt die Aufgabe zugrunde, mit einem geringen schaltungstechnischen Aufwand bei einem Elektromotor eine Verbesserung der Funkentstörung und damit eine verbesserte elektromagnetische Verträglichkeit von elektromotorisch angetriebenen Werkzeugen (EMV) zu erzielen.

Die Aufgabe wird mit den Merkmalen des Anspruchs 1 gelöst Zwischen den elektrischen Anschlüssen des Elektromotors ist eine Kondensatorbrücke aus zumindest zwei Entstörkondensatoren vorgesehen ist, die auf einer Platine der Filterschaltung platziert, wobei die Filterschaltung auf der Anschlussseite des Elektromotors angeordnet ist. Die verwendeten Entstörkondensatoren sind derart ausgebildet, dass sich in der Längsrichtung eines Entstörkondensators zwischen seinen elektrischen Anschlüssen eine Längsachse erstreckt, wobei die Entstörkondensatoren insbesondere ein- und derselben Kondensatorbrücke mit ihren Längsachsen in unterschiedlichen Raumrichtungen ausgerichtet mechanisch auf der Platine angeordnet sind.

Für eine signifikante Erhöhung der Funkentstörung ist nicht nur eine besondere elektrische Anordnung von Entstörkondensatoren an einem Elektromotor notwendig, sondern auch eine bestimmte mechanische Anordnung vorzugsweise relativ zum Elektromotor und insbesondere relativ zueinander. Bei einer Anordnung einer zwischen den Anschlüssen eines Elektromotors angeordneten Kondensatorbrücke wird eine bessere Funkentstörung erzielt, wenn die Entstörkondensatoren ein- und derselben Kondensatorbrücke in unterschiedlichen Raumrichtungen ausgerichtet werden.

Nach der Erfindung werden Entstörkondensatoren verwendet, die zwischen ihren elektrischen Anschlüssen eine Längsachse ausbilden. Die Anordnung eben dieser Entstörkondensatoren ist dann so vorzunehmen, dass die Längsachsen der Entstörkondensatoren derselben Kondensatorbrücke in ihrer Anordnungsebene in x/y-Richtung unterschiedlich ausgerichtet liegen.

Die Entstörkondensatoren einer Kondensatorbrücke sind mechanisch auf der Platine derart festgelegt, dass sie mit ihren Längsachsen in unterschiedlichen Raumrichtungen ausgerichtet liegen. Dadurch wird eine signifikant erhöhte elektromagnetische Verträglichkeit erzielt.

Eine Kondensatorbrücke bildet einen Leitungszweig aus, in dem zumindest zwei Entstörkondensatoren elektrisch in Reihe hintereinander geschaltet sind.

In Weiterbildung der Erfindung sind zumindest zwei Kondensatorbrücken vorgesehen, wobei die Leitungszweige der Kondensatorbrücke elektrisch zueinander parallel liegen. Durch diese Anordnung wird eine weitere Verbesserung der EMV-Verträglichkeit erzielt.

Eine vorteilhafte Anordnung der Entstörkondensatoren mehrerer Kondensatorbrücken wird erzielt, wenn ein Entstörkondensator des einen Leitungszweiges und ein Entstörkondensator des anderen Leitungszweiges derart mechanisch auf der Platine gehalten sind, dass ihre Längsachsen zueinander parallel liegen.

In Weiterbildung der Erfindung ist die mechanische Anordnung der Entstörkondensatoren von der Kondensatorbrücke auf der Platine derart vorgesehen, dass sie auf einem gemeinsamen, virtuellen Anordnungskreis liegen. Dabei ist die Anordnung der Entstörkondensatoren zweckmäßig so gewählt, dass die Längsachse eines Entstörkondensators eine Tangente an den Anordnungskreis bildet. Eine Anordnung der Längsachse eines Entstörkondensators in etwa als Tangente an den Anordnungskreis kann zur Erzielung der beabsichtigten Wirkung ausreichend sein.

Der virtuelle Anordnungskreis ist insbesondere so gewählt, dass er sich um die Rotationsachse des Rotors des Elektromotors erstreckt. Die Rotationsachse des Elektromotors liegt in einer zentralen Öffnung der Platine. Die Anordnung der Entstörkondensatoren ist dabei so gewählt, dass diese längs des Randes oder des Randbereichs der zentralen Öffnung der Platine angeordnet sind. Die Entstörkondensatoren am Rand der zentralen Öffnung liegen somit örtlich nahe dem Kollektor eines Gleichstrommotors, wodurch eine gute elektromagnetische Entstörung möglich wird.

Eine gute Entstörung wird erzielt, wenn die Entstörkondensatoren und die Kondensatorbrücken in Umfangsrichtung des Anordnungskreises mit gleichen räumlichen Abständen auf der Platine angeordnet sind.

Zweckmäßig haben alle Entstörkondensatoren einer Kondensatorbrücke die gleiche elektrische Größe. Insbesondere ist es vorteilhaft, alle Entstörkondensatoren der Kondensatorbrücken, insbesondere alle Kondensatoren der Filterschaltung in gleicher Größe auszuführen.

Für eine gute elektromagnetische Entstörung ist ferner vorgesehen, die Filterschaltung durch zumindest eine Drossel zu ergänzen. So kann in einer oder beiden elektrischen Zuleitungen zwischen der Versorgungsspannung und dem Elektromotor eine Drossel angeordnet sein, wobei die Kondensatorbrücke elektrisch zwischen der Drossel und dem Anschluss des Elektromotors angeschlossen ist. Als Drosseln werden vorteilhaft Stabkerndrosseln verwendet. Die Drosseln werden mechanisch auf der Platine der Filterschaltung festgelegt und elektrisch in die Filterschaltung eingebunden.

Neben der elektrischen Einbindung von zumindest einer Drossel in die Filterschaltung ist auch deren mechanische Anordnung auf der Platine der Filterschaltung von Bedeutung. So wird die Drossel vorteilhaft so angeordnet, dass ihre sich in einer Längsrichtung erstreckende Wickelachse zu einem virtuellen Anordnungskreis der Entstörkondensatoren radial ausgerichtet liegt. Ist sowohl im Minuspfad der Zuleitung als auch im Pluspfad der Zuleitung eine Drossel angeordnet, so werden deren mechanische Ausrichtungen so gewählt, dass ihre Wickelachsen zueinander gleichachsig liegen. Insbesondere liegen die Drosseln bezogen auf die zentrale Öffnung der Platine oder bezogen auf den virtuellen Anordnungskreis der Entstörkondensatoren einander diametral gegenüber.

In Weiterbildung der Erfindung ist der Elektromotor als Gleichstrommotor ausgeführt und treibt ein Werkzeug an, das an einem Ende eines Führungsrohres eines Arbeitsgerätes angeordnet ist. Das Führungsrohr besteht vorzugsweise aus einem elektrisch leitenden Material, wobei die Versorgungsspannung von dem anderen Ende des Führungsrohrs über eine in dem Führungsrohr verlegte Energieleitung dem Elektromotor zugeführt ist. Für eine erhöhte EMV-Verträglichkeit ist das elektrisch leitende Führungsrohr mit einem Potenzial der Versorgungsspannung verbunden. Insbesondere wird das Führungsrohr an seinem anderen, unteren Ende mit dem Potenzial der Versorgungsspannung verbunden. Als zweckmäßig hat sich erwiesen, das Führungsrohr mit dem Minuspol der Versorgungsspannung elektrisch leitend zu verbinden. Es kann vorteilhaft sein, statt einer Verbindung mit dem Minuspol der Versorgungsspannung alternativ eine Verbindung mit dem Pluspol der Versorgungsspannung herzustellen.

Die Versorgungsspannung für den Elektromotor wird von einer Steuerungselektronik zur Verfügung gestellt. Die Steuerungselektronik ist an dem dem Werkzeug gegenüberliegenden anderen Ende des Führungsrohrs angeordnet. Dabei wird die im Führungsrohr geführte Energieleitung durch das elektrisch leitende Führungsrohr selbst elektrisch geschirmt.

Weitere Merkmale der Erfindung ergeben sich aus den weiteren Ansprüchen, der nachfolgenden Beschreibung sowie den in den Zeichnungen dargestellten Ausführungsbeispielen. Die in den Ansprüchen, der Beschreibung und den Zeichnungen offenbarten Merkmale sind im Rahmen der Erfindung in beliebiger Weise untereinander kombinierbar. Es zeigen:
- Fig. 1: in einer ersten perspektivischen Ansicht ein Ausführungsbeispiel eines Arbeitsgerätes mit einem Führungsrohr und einem Werkzeug an dem einen sowie eine Energiequelle an dem anderen Ende des Führungsrohrs,
- Fig. 2: eine weitere perspektivische Ansicht des Arbeitsgerätes nach Fig. 1,
- Fig. 3: ein schematisches Schaltbild einer erfindungsgemäßen Filterschaltung,
- Fig. 4: eine perspektivische Darstellung der auf einer Platine angeordneten Filterschaltung,
- Fig. 5: eine perspektivische Ansicht eines Elektromotors mit auf dessen Anschlussseite angeordneter Filterschaltung auf einer Platine,
- Fig. 6: einen Schnitt durch eine Kupplungsvorrichtung zwischen zwei Rohrabschnitten sowie einer Steckverbindung für die in den Rohrabschnitten geführte Energieleitung,
- Fig. 7: eine schematische Darstellung des in Fig. 1 gezeigten Arbeitsgerätes mit einem aus mehreren Rohrabschnitten zusammengesetzten Führungsrohr im Schnitt,
- Fig. 8: einen Schnitt durch den Verbindungsbereich des Führungsrohres im Aufnahmegehäuse am unteren Ende des Führungsrohres.

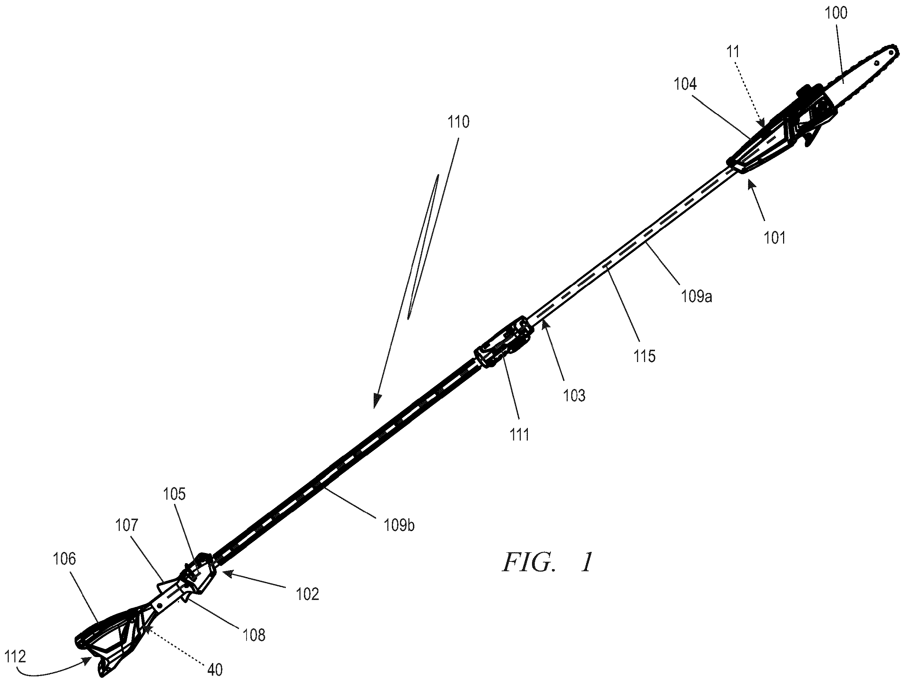

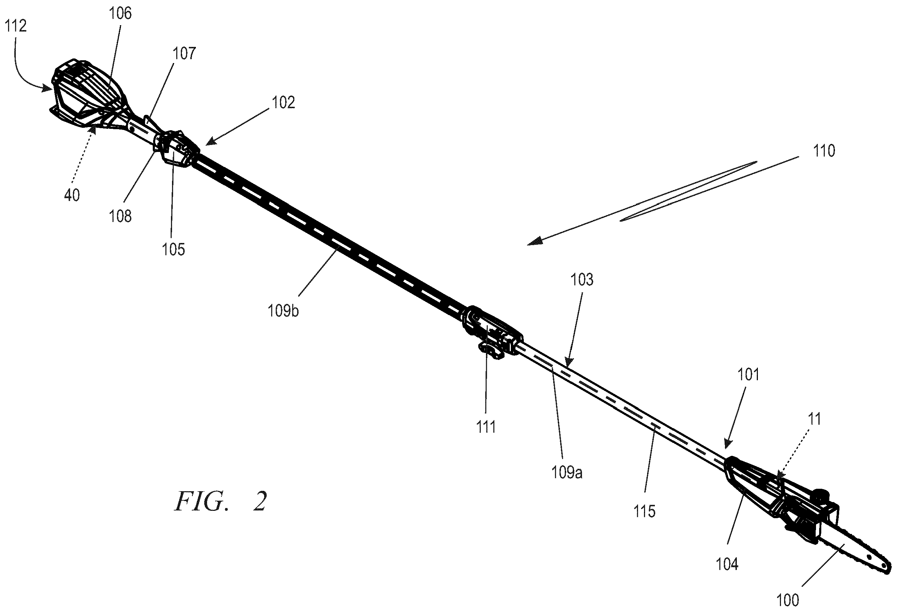

In den Fig. 1 und 2 ist beispielhaft ein Arbeitsgerät 110 gezeigt, welches auch als Langschaftgerät bezeichnet ist. Das Arbeitsgerät 110 weist ein Führungsrohr 103 auf, welches an dem einen Ende 101 ein Werkzeug 100 trägt. Das Werkzeug 100 wird von einem nicht näher dargestellten Elektromotor 11 angetrieben, welches in einem Antriebsgehäuse 104 an dem einen Ende 101 des Führungsrohrs 103 gehalten ist. Das Werkzeug 100 ist bevorzugt an dem Antriebsgehäuse 104 befestigt.

Der Elektromotor kann ein Gleichstrommotor in Form eines Kommutatormotors sein oder ein von einer Gleichspannung über eine Ansteuervorrichtung angesteuerter EC-Motor (z. B. ein Universalmotor, ein bürstenloser Gleichstrommotor oder ein elektronisch kommutierter Gleichstrommotor).

An dem anderen Ende 102 des Führungsrohres 103 ist ein Aufnahmegehäuse 106 gehalten, welches einen Aufnahmeschacht 112 zur Aufnahme eines Akkus oder dergleichen Energiequelle aufweist. Es kann zweckmäßig sein, als Energiequelle ein stationäres Versorgungsnetz zu nutzen, welches über eine elektrische Leitung mit dem Aufnahmegehäuse 106 bzw. mit einer im Aufnahmegehäuse 106 aufgenommenen Steuerungselektronik 40 verbunden ist. Das Aufnahmegehäuse 106 kann unmittelbar auf dem Ende 102 des Führungsrohres 103 befestigt sein.

Im gezeigten Ausführungsbeispiel ist auf dem Ende 102 des Führungsrohres 103 ein Bediengriff 105 mit Bedienelementen vorgesehen. Im gezeigten Ausführungsbeispiel sind als Bedienelemente ein als Betriebshebel 108 oder Gashebel bezeichnetes Bedienelement zur Steuerung des Elektromotors 11 im Antriebsgehäuse 104 sowie ein Sperrhebel 107 zur Sicherung des Betriebshebels 108 vorgesehen.

Das in den Fig. 1 und 2 gezeigte Führungsrohr 103 kann teleskopierbar sein. Im gezeigten Ausführungsbeispiel ist eine Steckverbindung gezeigt, die aus einem oberen Rohrabschnitt 109a mit dem Ende 101 und dem Antriebsgehäuse 104 und dem unteren Rohrabschnitt 109b mit dem Ende 102 und Bediengriff 105 sowie dem Aufnahmegehäuse 106 besteht. Mittels einer vorzugsweise am unteren Rohrabschnitt 109b gehaltenen Steckaufnahme mit einer Klemmvorrichtung 111 kann der obere Rohrabschnitt 109a am unteren Rohrabschnitt 109b festgelegt oder von diesem getrennt werden.

Wie in den Fig. 1 und 2 angedeutet, ist am oberen Ende 101 des Führungsrohrs 103 im Antriebsgehäuse 104 der Elektromotor 11 und am unteren Ende 102 des Führungsrohr 103 im Aufnahmegehäuse 106 eine Steuerungselektronik 40 vorgesehen. Der vorzugsweise als Gleichstrommotor ausgebildete Elektromotor 11 ist über eine Energieleitung 115 mit der Steuerungselektronik 40 elektrisch verbunden. In Abhängigkeit der Stellung des Betriebshebels 108 im Bediengriff 105 steuert die Steuerungselektronik 40 über die Energieleitung 115 den Betrieb des Elektromotors 11 zum Antrieb des Werkzeugs 100.

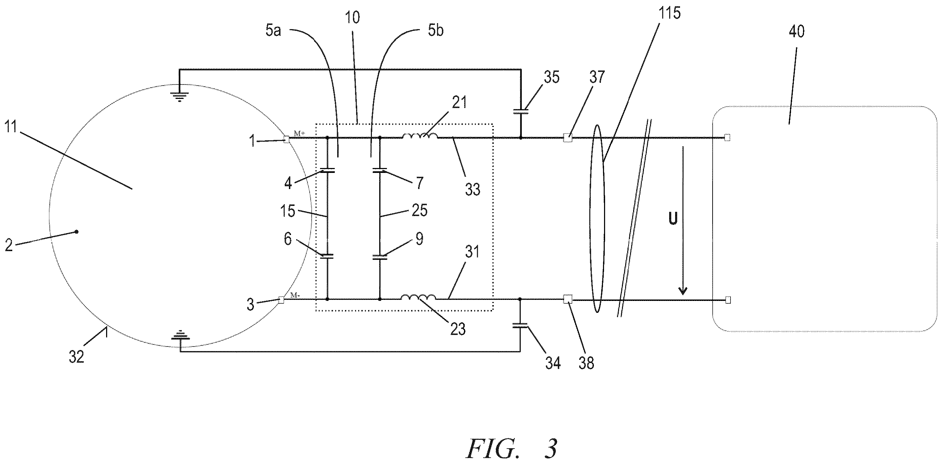

Ein schematischer Schaltplan einer an einem Elektromotor 11 elektrisch angeschlossenen Filterschaltung 10 ist in Fig. 3 wiedergegeben. Die Energieleitung 115 zwischen der Steuerungselektronik 40 und dem Elektromotor 11 besteht aus einer ersten, vorzugsweise ein negatives Potenzial führenden Zuleitung 33 und einer zweiten, vorzugsweise ein positives Potenzial führenden Zuleitung 31. Zwischen den Zuleitungen 31 und 33 liegt eine Versorgungsspannung U für den Elektromotor 11 an. Die Versorgungsspannung U ist von der Steuerungselektronik 40 in Abhängigkeit der Stellung des Betriebshebels 108 änderbar.

Um im Betrieb des Elektromotors 11 eine elektromagnetische Störung der Umgebung zu vermeiden, ist die Filterschaltung 10 vorzugsweise unmittelbar an dem Elektromotor 11 vorgesehen. Wird in dem Arbeitsgerät 110 als Antriebsmotor insbesondere ein Gleichstrommotor verwendet, kann in Abhängigkeit von Betriebszuständen am Kollektor ein Bürstenfeuer auftreten, welches elektromagnetische drahtlose und drahtgebundene Störungen verursachen kann.

Mit der erfindungsgemäßen erweiterten Filterschaltung 10 gemäß der Darstellung in Fig. 3 kann eine signifikante Entstörung des Elektromotors 11 und damit eine Erhöhung der elektromagnetischen Verträglichkeit (EMV) erzielt werden. Hierzu ist nicht nur die elektrische Anordnung von Entstörkondensatoren 4, 6, 7, 9 zweckmäßig, sondern darüber hinaus auch eine bestimmte mechanische Anordnung der Entstörkondensatoren 4, 6, 7, 9 relativ zueinander.

In Fig. 3 ist eine erfindungsgemäße Filterschaltung 10 gezeigt, die mechanisch auf der Anschlussseite 2 des Elektromotors 11 angeordnet ist. Zwischen den elektrischen Anschlüssen 1 und 3 des Elektromotors 11 ist elektrisch zumindest eine Kondensatorbrücke 5a, 5b angeschlossen, die jeweils aus zumindest zwei Entstörkondensatoren 4 und 6 bzw. 7 und 9 gebildet ist. Im gezeigten Ausführungsbeispiel nach Fig. 3 sind zwei Kondensatorbrücken 5a bzw. 5b vorgesehen, wobei jede Kondensatorbrücke 5a bzw. 5b einen Leitungszweig 15, 25 ausbildet. Die Leitungszweige 15 und 25 liegen zueinander parallel und sind elektrisch zwischen den Anschlüssen 1 und 3 des Elektromotors 11 angeschlossen.

In einem Leitungszweig 15 bzw. 25 der Kondensatorbrücke 5a bzw. 5b sind bevorzugt zwei Entstörkondensatoren 4, 6 bzw. 7, 9 vorgesehen. Die Entstörkondensatoren 4, 6 bzw. 7, 9 eines Leitungszweiges 15 bzw. 25 einer Kondensatorbrücke 5a bzw. 5b liegen elektrisch in Reihe hintereinander, bilden somit eine Reihenschaltung aus. Es kann vorteilhaft sein, wenn alle Entstörkondensatoren 4, 6, und 7, 9 einer Kondensatorbrücke 5a, 5b die gleiche elektrische Größe haben. Insbesondere haben alle Entstörkondensatoren 4, 6, 7, 9 aller Kondensatorbrücken 5a, 5b die gleiche elektrische Größe.

Aus dem schematischen Schaltbild nach Fig. 3 ist ferner ersichtlich, dass in den elektrischen Zuleitungen 31 und 33 zwischen der Versorgungsspannung U bzw. der Steuerungselektronik 40 und dem Elektromotor 11 eine Drossel 21 bzw. 23 geschaltet ist. Vorzugsweise ist die Drossel 21, 23 eine Stabkerndrossel. Der elektrische Anschluss der Drosseln 21 und 23 ist derart vorgesehen, dass die Kondensatorbrücken 5a und 5b elektrisch einerseits an den Leitungsabschnitt zwischen der Drossel 21 und dem Anschluss 1 des Elektromotors 11 und andererseits an den Leitungsabschnitt zwischen der Drossel 23 und dem Anschluss 2 des Elektromotors 11 angeschlossen sind.

Die elektrische Größe der Induktivität der Drosseln 21 und 23 ist zweckmäßig gleich. Die elektrische Größe der Induktivität liegt vorzugsweise zwischen 1 µH und 4 µH, insbesondere beträgt die elektrische Größe der Induktivität 2 µH.

In Weiterbildung der Erfindung ist zwischen der elektrischen Zuleitung 31 und einem elektrisch leitenden Motorgehäuse 32 des Elektromotors 11 ein weiterer Kondensator 34 angeschlossen. Entsprechend ist zwischen der Zuleitung 33 und dem elektrisch leitenden Muttergehäuse 32 ein weiterer Kondensator 35 angeschlossen. Die Kondensatoren 34 bzw. 35 sind an einem Leitungsabschnitt der Minus-Zuleitung 31 bzw. an einem Leitungsabschnitt der Plus-Zuleitung 33 elektrisch angeschlossen, der sich zwischen der Drossel 21 bzw. 23 und der Steuerungselektronik 40 erstreckt.

In besonderer Ausgestaltung der Erfindung haben alle im elektrischen Schaltbild nach Fig. 3 gezeigten Entstörkondensatoren 4, 6, 7, 9 und vorzugsweise auch die weiteren Kondensatoren 34 und 35 die gleiche elektrische Größe. Eine zweckmäßige elektrische Größe liegt zwischen 0,5 nF und 3 nF, insbesondere bei 1 nF.

Neben der elektrischen Anordnung der elektrischen Bauteile der erfindungsgemäßen Filterschaltung 10 ist deren mechanische Anordnung von Bedeutung, insbesondere auch deren mechanische Anordnung relativ zueinander.

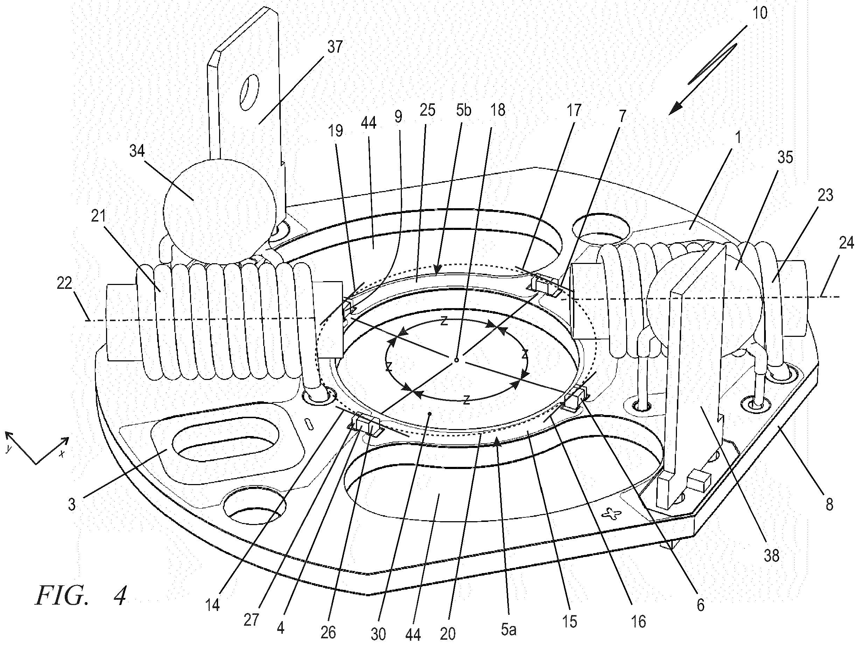

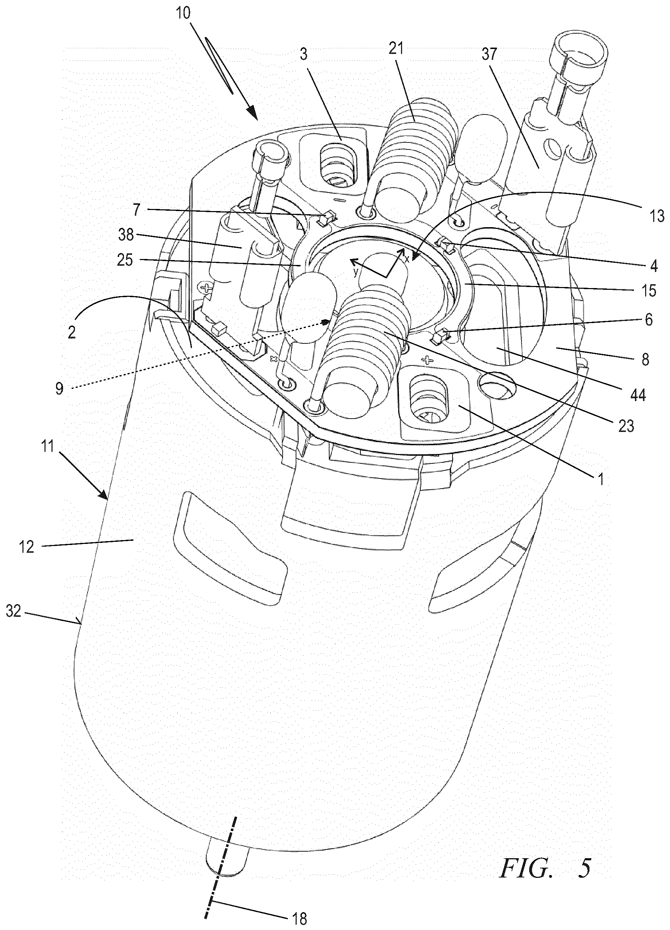

Wie Fig. 4 zeigt, ist die Filterschaltung 10 auf einer Platine 8 angeordnet. Die Platine 8 ist mechanisch auf der Anschlussseite 2 des Elektromotors 11 festgelegt, wie in Fig. 5 gezeigt. Im gezeigten Ausführungsbeispiel hat die Platine 8 eine etwa kreisringförmige Grundform mit einer zentralen Öffnung 30. Auf der Platine 8 sind Leiterbahnen ausgebildet, die unter anderem die Leitungszweige 15 und 25 der Kondensatorbrücken 5a und 5b ausbilden. Wie in Fig. 5 gezeigt, sind die Kondensatoren 4, 6, 7, 9 der Kondensatorbrücken 5a und 5b auf einem Anordnungskreis 20 rund um die zentrale Öffnung 30 vorgesehen. Der Anordnungskreis 20 erstreckt sich vorteilhaft um die Rotationsachse 18 des Rotors 13 des Elektromotors, wie insbesondere Fig. 5 zeigt.

Bevorzugt sind zwischen der zentralen Öffnung 30 der Platine 8 und deren Außenrand Platinenöffnungen 44 ausgebildet, die jeweils als Durchlass für die den Elektromotor 11 axial durchströmende Kühlluft dienen. Im gezeigten Ausführungsbeispiel nach den Fig. 4 und 5 sind in der Platine 8 zwei Platinenöffnungen 44 vorgesehen, die vorzugsweise eine teilringförmige Grundform haben. Die Platinenöffnungen 44 haben insbesondere eine gleiche Größe und können - bezogen auf die Rotationsachse 18 des Elektromotors 11 - einander vorzugsweise diametral gegenüberliegen.

Die Entstörkondensatoren 4, 6, 7, 9 haben vorzugsweise gleiche Bauform und sind insbesondere als SMD-Bauteile ausgebildet. Insbesondere hat jeder der Entstörkondensatoren 4, 6, 7, 9 einen im Wesentlichen quaderförmigen Grundkörper mit an den Stirnseiten des Grundkörpers ausgebildeten Kontaktkappen 26, 27, die die elektrischen Anschlüsse des Entstörkondensators 4, 6, 7, 9 bilden. In Längsrichtung eines Entstörkondensators 4, 6, 7, 9 ist zwischen seinen insbesondere durch die elektrischen Kontaktkappen 26 und 27 gebildeten Anschlüssen eine Längsachse 14, 16, 17, 19 ausgebildet.

Die mechanische Anordnung der Entstörkondensatoren 4, 6, 7, 9 auf der Platine 8 ist dabei so vorgesehen, dass die Entstörkondensatoren 4, 6 bzw. 7, 9 einer Kondensatorbrücke 5a bzw. 5b mit ihren Längsachsen 14, 16 bzw. 17, 19 in unterschiedlichen Raumrichtungen x/y orientiert auf der Platine 8 festgelegt sind. Wie Fig. 5 zeigt, liegen die Entstörkondensatoren 4 und 6 im Leitungszweig 15 der Kondensatorbrücke 5a mit ihren Längsachsen 14 und 16 in einem Winkel relativ zueinander. Die Entstörkondensatoren 4 und 6 der Kondensatorbrücke 5a und die Entstörkondensatoren 7 und 9 der Kondensatorbrücke 5b liegen insbesondere etwa in einer x/y-Ebene auf einem insbesondere gemeinsamen Anordnungskreis 20. Dabei ist die Anordnung so getroffen, dass die Längsachsen 14, 16, 17, 19 der Entstörkondensatoren 4, 6, 7, 9 nach Art einer Tangente an dem Anordnungskreis 20 liegen. Vorteilhaft ist vorgesehen, dass die Entstörkondensatoren einer Kondensatorbrücke 5a, 5b in Umfangsrichtung des Anordnungskreises 20 mit räumlichem Winkelabstand z auf der Platine 8 festliegen. Aufgrund des räumlichen Winkelabstandes z auf dem Anordnungskreis 20 liegen die Längsachsen 14, 16 bzw. 17, 19 der Entstörkondensatoren 4, 6 bzw. 7, 9 mit einem Winkel zueinander. Im gezeigten Ausführungsbeispiel beträgt der Winkel zwischen den Längsachsen 14, 16 bzw. 17, 19 der Entstörkondensatoren 4, 6 bzw. 7, 9 etwa 90°; ein Winkel zwischen den Längsachsen der Entstörkondensatoren einer Kondensatorbrücke 5a, 5b liegt vorteilhaft zwischen 10° und 170°. In besonderer Ausgestaltung der Erfindung liegen alle Entstörkondensatoren 4, 6, 7, 9 aller Kondensatorbrücken 5a, 5b auf dem Anordnungskreis 20 mit einem gleichen Umfangswinkelabstand z zueinander. Es kann vorteilhaft sein, die Entstörkondensatoren 4, 6, 7, 9 derart mechanisch auf der Platine 8 anzuordnen, dass ein Entstörkondensator 4 oder 6 des ersten Leitungszweiges 15 der ersten Kondensatorbrücke 5a und ein Entstörkondensator 7 oder 9 des zweiten Leitungszweiges 25 der zweiten Kondensatorbrücke 5b mit ihren Längsachsen 14 und 17 bzw. 16 und 19 zueinander parallel liegen.

Die im Schaltbild nach Fig. 3 in den Zuleitungen 31 und 33 gezeigten Drosseln 21 und 23 sind mechanisch auf der Platine 8 der Filterschaltung 10 gehalten. Die Drosseln 21 und 23 haben eine sich in einer Längsrichtung erstreckende Wickelachse 22 bzw. 24. Die mechanische Anordnung der Drosseln 21 und 23 auf der Platine 8 ist so vorgesehen, dass ihre Wickelachsen 22 und 24 zu dem virtuellen Anordnungskreis 20 der Entstörkondensatoren 4, 6, 7, 9 der Kondensatorbrücken 5a und 5b radial ausgerichtet liegen. Insbesondere ist die mechanische Anordnung der Drosseln 21 und 23 derart vorgesehen, dass sie mit ihren Wickelachsen 22 und 24 zueinander gleichachsig liegen. Bezogen auf die Rotationsachse 18 oder den Anordnungskreis 20 liegen die Wickelachsen 22 und 24 der Drosseln 21 und 23 einander insbesondere diametral gegenüber. Auch in der diametralen Anordnung liegen die Wickelachsen 22 und 24 gleichachsig zueinander.

Die die Filterschaltung 10 tragende Platine 8 ist mechanisch auf der Anschlussseite 2 des Elektromotors 11 festgelegt, wie Fig. 5 zeigt. Über Steckanschlüsse 37 und 38 wird die Platine 8 an die Energieleitung 115 angeschlossen, wie dies auch in Fig. 3 dargestellt ist. Die Anschlüsse 1 und 3 der Platine 8 dienen der elektrischen Verbindung mit dem Elektromotor 11.

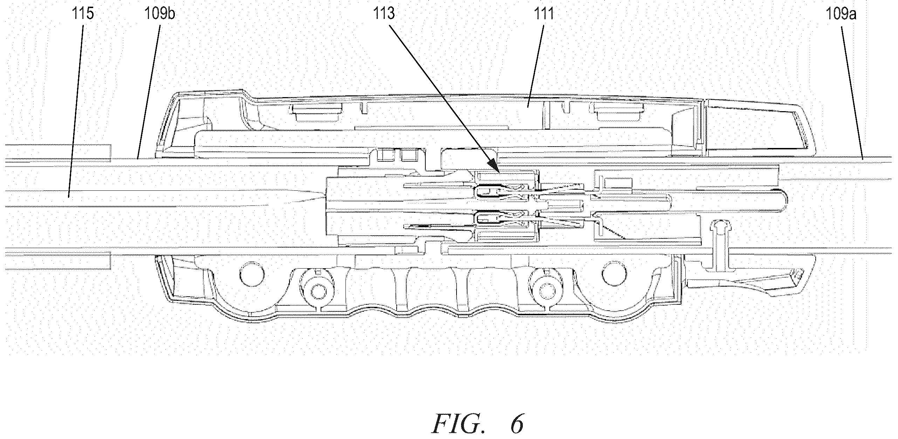

In Fig. 6 ist in schematischer Darstellung ein Schnitt durch eine Klemmvorrichtung 111 dargestellt, wie sie in den Fig. 1 und 2 gezeigt ist. Um das Führungsrohr 103 und die im Führungsrohr 103 geführte Energieleitung 115 zum Beispiel für einen Transport des Arbeitsgerätes trennen zu können, ist in der Klemmvorrichtung 111 eine Vorrichtung 113 als Stecker/Steckbuchse vorgesehen, die eine Trennung der Energieleitung 115 durch einfaches Auseinanderziehen der Rohrabschnitte 109a und 109b ebenso ermöglicht wie ein einfaches Zusammenstecken.

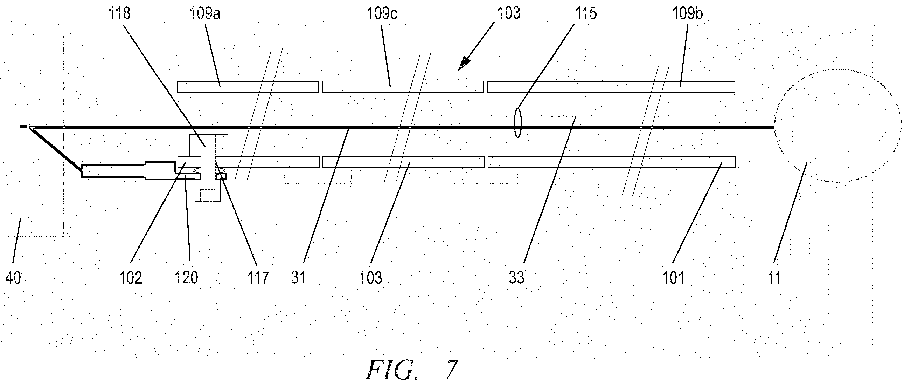

In Fig. 7 ist schematisch ein Führungsrohr 103 gezeigt, welches aus einem unteren Rohrabschnitt 109a, einem oberen Rohrabschnitt 109b und einem Zwischenrohrabschnitt 109c zusammengesetzt ist. Das gezeigte Führungsrohr 103 besteht ebenso wie das in den Fig. 1 und 2 gezeigte Führungsrohr 103 aus einem elektrisch leitenden Material, so dass eine im Führungsrohr 103 geführte Energieleitung 115 elektrisch geschirmt ist. Dadurch kann eine Umfeldbelastung durch elektromagnetische Strahlung weiter reduziert werden. Um eine elektrische Verbindung zwischen den gesteckten Rohrabschnitten sicherzustellen, sind die Rohrabschnitte vorzugsweise durch eine elektrische leitende Muffe miteinander zu verbinden. Insbesondere ist die elektrische Verbindung der Energieleitung 115 zwischen zwei Rohrabschnitten durch eine lösbare elektrische Steckverbindung 113 hergestellt, wie z. B. in Fig. 6 dargestellt.

Vorteilhaft wird das elektrisch leitende Führungsrohr 103 mit einem Potenzial der Versorgungsspannung U elektrisch leitend verbunden. Dadurch wird eine gute elektromagnetische Abschirmung erzielt. Wie in Fig. 7 an einem Ausführungsbeispiel eines zusammengesetzten Führungsrohrs 103 dargestellt, wird das Führungsrohr 103 an seinem unteren Ende 102 mit einem Potenzial der Versorgungsspannung U verbunden. Die Anbindung an die Versorgungsspannung U erfolgt in unmittelbarer Nähe der Steuerungselektronik 40. Zweckmäßig wird das elektrisch leitende Führungsrohr 103 mit dem Minuspol der Versorgungsspannung U verbunden.

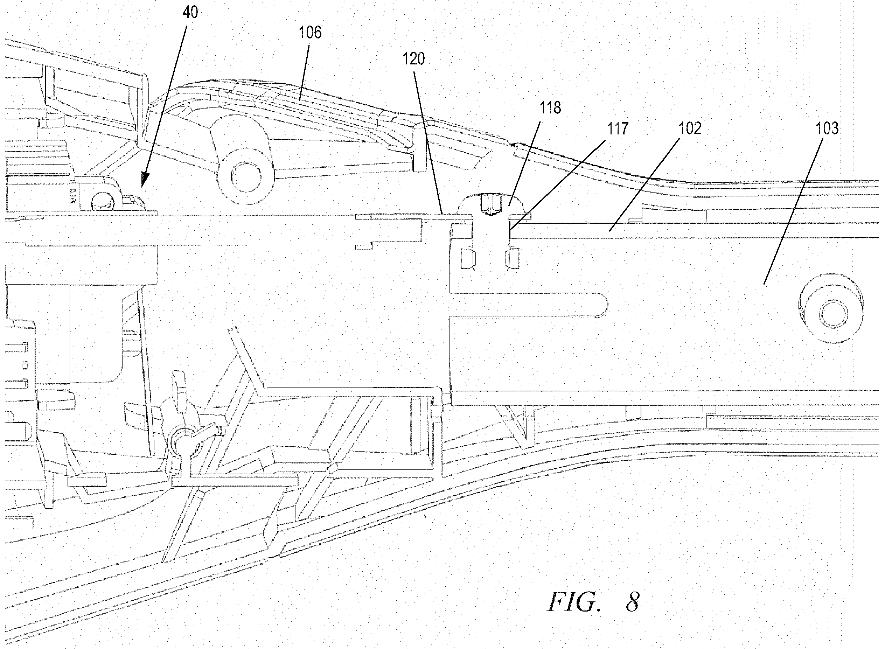

In Fig. 8 ist ein Teilschnitt durch das Aufnahmegehäuse 106 mit der darin angeordneten Steuerungselektronik 40 gezeigt. Das in das Aufnahmegehäuse 106 eingeführte untere Ende 102 des Führungsrohrs 103 weist in der Rohrwandung eine Montageöffnung 117 für eine Klemmschraube 118 auf. Mittels der Klemmschraube 118 wird ein insbesondere als Flachleitung 120 oder Erdungsband ausgebildeter elektrischer Anschluss elektrisch leitend an der Rohrwandung des Führungsrohrs 103 festgelegt. Über die Flachleitung 120 wird das Führungsrohr 103 elektrisch leitend an ein Potenzial der Versorgungsspannung, insbesondere an den Minuspol der Versorgungsspannung angeschlossen. Dadurch kann eine signifikante Reduktion der elektromagnetischen Störabstrahlung erzielt werden.

## Patentansprüche

1. Filterschaltung an einem Elektromotor, wobei der Elektromotor (11) einen Rotor (13) aufweist, und der Elektromotor (11) Anschlüsse (1, 3) zur elektrischen Verbindung des Elektromotors (11) mit einer Versorgungsspannung (U) aufweist, wobei die Anschlüsse (1, 3) des Elektromotors (11) auf einer Anschlussseite (2) des Elektromotors (11) vorgesehen sind, und die Filterschaltung (10) zumindest eine zwischen den elektrischen Anschlüssen (1, 3) des Elektromotors (11) angeordnete Kondensatorbrücke (5a, 5b) aufweist, wobei die zwischen den elektrischen Anschlüssen (1, 3) des Elektromotors (11) angeordnete Kondensatorbrücke (5a, 5b) zumindest zwei Entstörkondensatoren (4, 6; 7, 9) aufweist, wobei die Kondensatorbrücke (5a, 5b) einen Leitungszweig (15, 25) ausbildet, und in dem Leitungszweig (15, 25) zumindest zwei Entstörkondensatoren (4, 6; 7, 9) elektrisch in Reihe hintereinander geschaltet sind, und die Filterschaltung (10) auf einer Platine (8) angeordnet ist, wobei die Platine (8) mit der Filterschaltung (10) auf der Anschlussseite (2) des Elektromotors (11) gehalten ist,
**dadurch gekennzeichnet,**
**dass** ein Entstörkondensator (4, 6, 7, 9) des Leitungszweiges (15, 25) derart ausgebildet ist, dass sich in Längsrichtung des Entstörkondensators (4, 6, 7, 9) zwischen seinen elektrischen Anschlüssen eine Längsachse (14, 16, 17, 19) erstreckt, und dass die Entstörkondensatoren (4, 6, 7, 9) der Kondensatorbrücke (5a, 5b) mit ihren Längsachsen (14, 16, 17, 19) in unterschiedlichen Raumrichtungen (x, y) ausgerichtet auf der Platine (8) angeordnet sind.

2. Filterschaltung nach Anspruch 1,
**dadurch gekennzeichnet, dass** zumindest zwei Kondensatorbrücken (5a, 5b) vorgesehen sind und die Leitungszweige (15, 25) der Kondensatorbrücken (5a, 5b) elektrisch zueinander parallel liegen.

3. Filterschaltung nach Anspruch 1 oder 2,
**dadurch gekennzeichnet, dass** ein Entstörkondensator (4, 6) des einen Leitungszweiges (15) und ein Entstörkondensator (7, 9) des anderen Leitungszweiges (25) derart mechanisch auf der Platine (8) gehalten sind, dass ihre Längsachsen (14, 16; 17, 19) zueinander parallel liegen.

4. Filterschaltung nach einem der Ansprüche 1 bis 3,
**dadurch gekennzeichnet, dass** die Entstörkondensatoren (4, 6, 7, 9) der Kondensatorbrücken (5a, 5b) derart mechanisch auf der Platine (8) angeordnet sind, dass sie auf einem gemeinsamen virtuellen Anordnungskreis (20) liegen, wobei die Längsachse (14, 16, 17, 19) eines Entstörkondensators (4, 6, 7, 9) jeweils eine Tangente an den Anordnungskreis (20) bildet.

5. Filterschaltung nach Anspruch 4,
**dadurch gekennzeichnet, dass** der Rotor (13) des Elektromotors (11) eine Rotationsachse (18) aufweist und sich der Anordnungskreis (20) um die Rotationsachse (18) des Rotors (13) erstreckt.

6. Filterschaltung nach Anspruch 4 oder 5,
**dadurch gekennzeichnet, dass** die Entstörkondensatoren (4, 6, 7, 9) der Kondensatorbrücke (5a, 5b) in Umfangsrichtung des Anordnungskreises (20) mit gleichen räumlichen Abständen (z) auf der Platine (8) angeordnet sind.

7. Filterschaltung nach einem der Ansprüche 1 bis 6,
**dadurch gekennzeichnet, dass** alle Entstörkondensatoren (4, 6, 7, 9) der Kondensatorbrücke (5a, 5b) die gleiche elektrische Größe haben.

8. Filterschaltung nach einem der Ansprüche 1 bis 7,
**dadurch gekennzeichnet, dass** in der elektrischen Zuleitung (31, 33) zwischen der Versorgungsspannung (U) und dem Elektromotor (11) eine Drossel (21, 23), insbesondere eine Stabkerndrossel geschaltet ist, wobei die Kondensatorbrücke (5a, 5b) elektrisch zwischen der Drossel (21, 23) und dem Anschluss (1, 3) des Elektromotors (11) angeschlossen ist.

9. Filterschaltung nach Anspruch 8,
**dadurch gekennzeichnet, dass** die Drossel (21, 23) mechanisch auf der Platine (8) der Filterschaltung (10) gehalten ist.

10. Filterschaltung nach Anspruch 8 oder 9,
**dadurch gekennzeichnet, dass** die Drossel (21, 23) eine sich in einer Längsrichtung erstreckende Wickelachse (22, 24) aufweist, wobei die Wickelachse (22, 24) der Drossel (21, 23) zu einem virtuellen Anordnungskreis (20) der Entstörkondensatoren (4, 6, 7, 9) radial ausgerichtet liegt.

11. Filterschaltung nach einem der Ansprüche 8 bis 10,
**dadurch gekennzeichnet, dass** sowohl im Minuspfad der Zuleitung (31) als auch im Pluspfad der Zuleitung (33) eine Drossel (21, 23) angeordnet ist, und die Drosseln (21, 23) mit ihren Wickelachsen (22, 24) zueinander gleichachsig liegen.

12. Filterschaltung nach einem der Ansprüche 1 bis 10,
**dadurch gekennzeichnet, dass** der Elektromotor (11) ein Gleichstrommotor ist und ein Werkzeug (100) antreibt, dass das Werkzeug (100) an einem Ende (101) eines Führungsrohres (103) angeordnet ist, das aus einem elektrisch leitenden Material besteht, und dass die Versorgungsspannung (U) von dem anderen Ende (102) des Führungsrohres (103) über eine in dem Führungsrohr (103) verlegte Energieleitung (115) dem Elektromotor (11) zugeführt ist, wobei das Führungsrohr (103) mit einem Potenzial der Versorgungsspannung (U) elektrisch leitend verbunden ist.

13. Filterschaltung nach Anspruch 12,
**dadurch gekennzeichnet, dass** das Führungsrohr (103) an seinem anderen Ende (102) mit einem Potenzial der Versorgungsspannung (U), insbesondere mit dem Minuspol der Versorgungsspannung (U) elektrisch leitend verbunden ist.

14. Filterschaltung nach einem der Ansprüche 1 bis 12,
**dadurch gekennzeichnet, dass** die Versorgungsspannung (U) von einer Steuerungselektronik (40) für den Elektromotor (11) zur Verfügung gestellt ist, wobei die Steuerungselektronik (40) an dem anderen Ende (102) des Führungsrohres (103) angeordnet ist.

## Claims

1. Filter circuit on an electric motor, wherein the electric motor (11) has a rotor (13), and the electric motor (11) has connections (1, 3) for electrical connection of the electric motor (11) to a supply voltage (U), wherein the connections (1, 3) of the electric motor (11) are provided on a connection end (2) of the electric motor (11), and the filter circuit (10) has at least one capacitor bridge (5a, 5b) arranged between the electrical connections (1, 3) of the electric motor (11), wherein the capacitor bridge (5a, 5b) arranged between the electrical connections (1, 3) of the electric motor (11) has at least two interference suppression capacitors (4, 6; 7, 9), wherein the capacitor bridge (5a, 5b) forms a conductor branch (15, 25), and at least two interference suppression capacitors (4, 6;, 7, 9) are electrically connected in series in the conductor branch (15, 25), one after another, and the filter circuit (10) is arranged on a circuit board (8), wherein the circuit board (8) with the filter circuit (10) is held on the connection end (2) of the electric motor (11),
**characterized**
**in that** an interference suppression capacitor (4, 6, 7, 9) of the conductor branch (15, 25) is designed in such a way that a longitudinal axis (14, 16, 17, 19) extends between the electrical connections of said interference suppression capacitor (4, 6, 7, 9) in its longitudinal direction, and in that the interference suppression capacitors (4, 6, 7, 9) of the capacitor bridge (5a, 5b) are arranged on the circuit board (8) with their longitudinal axes (14, 16, 17, 19) aligned in different spatial directions (x, y).

2. Filter circuit according to claim 1,
**characterized in that** at least two capacitor bridges (5a, 5b) are provided and the conductor branches (15, 25) of the capacitor bridges (5a, 5b) lie electrically parallel to one another.

3. Filter circuit according to claim 1 or 2,
**characterized in that** an interference suppression capacitor (4, 6) of one conductor branch (15) and an interference suppression capacitor (7, 9) of the other conductor branch (25) are mechanically held on the circuit board (8) in such a way that their longitudinal axes (14, 16; 17, 19) lie parallel to one another.

4. Filter circuit according to one of claims 1 to 3,
**characterized in that** the interference suppression capacitors (4, 6, 7, 9) of the capacitor bridges (5a, 5b) are mechanically mounted on the circuit board (8) in such a way that they lie on a common virtual mounting circle (20), wherein the longitudinal axis (14, 16, 17, 19) of an interference suppression capacitor (4, 6, 7, 9) forms a tangent to the mounting circle (20) in each case.

5. Filter circuit according to claim 4,
**characterized in that** the rotor (13) of the electric motor (11) has a rotation axis (18) and the mounting circle (20) extends around the rotation axis (18) of the rotor (13).

6. Filter circuit according to claim 4 or 5,
**characterized in that** the interference suppression capacitors (4, 6, 7, 9) of the capacitor bridge (5a, 5b) are arranged on the circuit board (8) at equal spatial distances (z) in the circumferential direction of the mounting circle (20).

7. Filter circuit according to one of claims 1 to 6,
**characterized in that** all interference suppression capacitors (4, 6, 7, 9) of the capacitor bridge (5a, 5b) have the same electrical value.

8. Filter circuit according to one of claims 1 to 7,
**characterized in that** a choke (21, 23), in particular a rod core choke, is connected in the electrical supply line (31, 33) between the supply voltage (U) and the electric motor (11), wherein the capacitor bridge (5a, 5b) is electrically connected between the choke (21, 23) and the connection (1, 3) of the electric motor (11).

9. Filter circuit according to claim 8,
**characterized in that** the choke (21, 23) is mechanically held on the circuit board (8) of the filter circuit (10).

10. Filter circuit according to claim 8 or 9,
**characterized in that** the choke (21, 23) has a winding axis (22, 24) extending in a longitudinal direction, wherein the winding axis (22, 24) of the choke (21, 23) is aligned radially with respect to a virtual mounting circle (20) of the interference suppression capacitors (4, 6, 7, 9).

11. Filter circuit according to one of claims 8 to 10,
**characterized in that** a choke (21, 23) is arranged both in the negative path of the supply line (31) and in the positive path of the supply line (33), and the chokes (21, 23) lie with their winding axes (22, 24) coaxial to one another.

12. Filter circuit according to one of claims 1 to 10,
**characterized in that** the electric motor (11) is a direct current motor and drives a tool (100), **in that** the tool (100) is arranged at one end (101) of a guide tube (103), which consists of an electrically conductive material, and **in that** the supply voltage (U) is fed to the electric motor (11) from the other end (102) of the guide tube (103) via a power cable (115) installed in the guide tube (103), wherein the guide tube (103) is electroconductively connected to a potential of the supply voltage (U).

13. Filter circuit according to claim 12,
**characterized in that** the guide tube (103) is electroconductively connected to a potential of the supply voltage (U), in particular to the negative pole of the supply voltage (U), at its other end (102).

14. Filter circuit according to one of claims 1 to 12,
**characterized in that** the supply voltage (U) is provided by control electronics (40) for the electric motor (11), wherein the control electronics (40) are arranged at the other end (102) of the guide tube (103).

## Revendications

1. Circuit de filtrage sur un moteur électrique, le moteur électrique (11) comportant un rotor (13), et le moteur électrique (11) comportant des bornes (1, 3) pour la connexion électrique du moteur électrique (11) à une tension d'alimentation (U), les bornes (1, 3) du moteur électrique (11) étant prévues sur un côté de raccordement (2) du moteur électrique (11), et le circuit de filtrage (10) comportant au moins un pont de condensateurs (5a, 5b) agencé entre les bornes électriques (1, 3) du moteur électrique (11), le pont de condensateurs (5a, 5b) agencé entre les bornes électriques (1, 3) du moteur électrique (11) comportant au moins deux condensateurs de déparasitage (4, 6 ; 7, 9), le pont de condensateurs (5a, 5b) formant une branche de ligne (15, 25), et au moins deux condensateurs de déparasitage (4, 6 ; 7, 9) étant connectés électriquement en série dans la branche de ligne (15, 25), et le circuit de filtrage (10) étant agencé sur une carte (8), la carte (8) dotée du circuit de filtrage (10) étant maintenue sur le côté de raccordement (2) du moteur électrique (11),
**caractérisé**
**en ce qu'**un condensateur de déparasitage (4, 6, 7, 9) de la branche de ligne (15, 25) est conçu de telle sorte qu'un axe longitudinal (14, 16, 17, 19) s'étende dans la direction longitudinale du condensateur de déparasitage (4, 6, 7, 9) entre ses bornes électriques, et **en ce que** les condensateurs de déparasitage (4, 6, 7, 9) du pont de condensateurs (5a, 5b) sont agencés sur la carte (8) en étant orientés avec leurs axes longitudinaux (14, 16, 17, 19) dans des directions spatiales (x, y) différentes.

2. Circuit de filtrage selon la revendication 1,
**caractérisé en ce qu'**il est prévu au moins deux ponts de condensateurs (5a, 5b) et **en ce que** les branches de ligne (15, 25) des ponts de condensateurs (5a, 5b) sont électriquement parallèles l'une à l'autre.

3. Circuit de filtrage selon la revendication 1 ou 2,
**caractérisé en ce qu'**un condensateur de déparasitage (4, 6) de l'une des branches de ligne (15) et un condensateur de déparasitage (7, 9) de l'autre branche de ligne (25) sont maintenus mécaniquement sur la carte (8) de telle sorte que leurs axes longitudinaux (14, 16 ; 17, 19) soient parallèles l'un à l'autre.

4. Circuit de filtrage selon l'une quelconque des revendications 1 à 3,
**caractérisé en ce que** les condensateurs de déparasitage (4, 6, 7, 9) des ponts de condensateurs (5a, 5b) sont agencés mécaniquement sur la carte (8) de telle sorte qu'ils se trouvent sur un cercle d'agencement virtuel (20) commun, l'axe longitudinal (14, 16, 17, 19) d'un condensateur de déparasitage (4, 6, 7, 9) formant respectivement une tangente au cercle d'agencement (20).

5. Circuit de filtrage selon la revendication 4,
**caractérisé en ce que** le rotor (13) du moteur électrique (11) présente un axe de rotation (18) et **en ce que** le cercle d'agencement (20) s'étend autour de l'axe de rotation (18) du rotor (13).

6. Circuit de filtrage selon la revendication 4 ou 5,
**caractérisé en ce que** les condensateurs de déparasitage (4, 6, 7, 9) du pont de condensateurs (5a, 5b) sont agencés sur la carte (8) dans la direction circonférentielle du cercle d'agencement (20) avec des espacements spatiaux (z) égaux.

7. Circuit de filtrage selon l'une quelconque des revendications 1 à 6,
**caractérisé en ce que** tous les condensateurs de déparasitage (4, 6, 7, 9) du pont de condensateurs (5a, 5b) présentent la même valeur électrique.

8. Circuit de filtrage selon l'une quelconque des revendications 1 à 7,
**caractérisé en ce qu'**une self (21, 23), en particulier une self à noyau en barreau, est connectée sur la ligne d'alimentation électrique (31, 33) entre la tension d'alimentation (U) et le moteur électrique (11), le pont de condensateurs (5a, 5b) étant connecté électriquement entre la self (21, 23) et la borne (1, 3) du moteur électrique (11).

9. Circuit de filtrage selon la revendication 8,
**caractérisé en ce que** la self (21, 23) est maintenue mécaniquement sur la carte (8) du circuit de filtrage (10).

10. Circuit de filtrage selon la revendication 8 ou 9,
**caractérisé en ce que** la self (21, 23) présente un axe d'enroulement (22, 24) s'étendant dans une direction longitudinale, l'axe d'enroulement (22, 24) de la self (21, 23) étant orienté radialement par rapport à un cercle d'agencement virtuel (20) des condensateurs de déparasitage (4, 6, 7, 9).

11. Circuit de filtrage selon l'une quelconque des revendications 8 à 10,
**caractérisé en ce qu'**une self (21, 23) est agencée à la fois sur le trajet négatif de la ligne d'alimentation (31) et sur le trajet positif de la ligne d'alimentation (33), et **en ce que** les selfs (21, 23) avec leurs axes d'enroulement (22, 24) sont disposées coaxialement l'une par rapport à l'autre.

12. Circuit de filtrage selon l'une quelconque des revendications 1 à 10,
**caractérisé en ce que** le moteur électrique (11) est un moteur à courant continu et entraîne un outil (100), **en ce que** l'outil (100) est agencé à une extrémité (101) d'un tube de guidage (103) qui est constitué d'un matériau électriquement conducteur, et **en ce que** la tension d'alimentation (U) est fournie au moteur électrique (11) depuis l'autre extrémité (102) du tube de guidage (103) par l'intermédiaire d'une ligne d'énergie (115) posée dans le tube de guidage (103), le tube de guidage (103) étant relié de manière électriquement conductrice à un potentiel de la tension d'alimentation (U).

13. Circuit de filtrage selon la revendication 12,
**caractérisé en ce que** le tube de guidage (103) est relié de manière électriquement conductrice par son autre extrémité (102) à un potentiel de la tension d'alimentation (U), en particulier au pôle négatif de la tension d'alimentation (U).

14. Circuit de filtrage selon l'une quelconque des revendications 1 à 12,
**caractérisé en ce que** la tension d'alimentation (U) est mise à disposition par une électronique de commande (40) destinée au moteur électrique (11),
l'électronique de commande (40) étant agencée à l'autre extrémité (102) du tube de guidage (103).
